# EUROPEAN PATENT SPECIFICATION

(11) **EP 2 321 446 B1**
(45) Date of publication and mention of the grant of the patent: **10.05.2017**
(21) Application number: 09788829.1
(22) Date of filing: 23.06.2009
(51) Int. Cl.: C23C 16/24, C23C 16/46, C01B 33/035

(54) **CHUCK AND BRIDGE CONNECTION POINTS FOR TUBE FILAMENTS IN A CHEMICAL VAPOR DEPOSITION REACTOR**
SPANNVORRICHTUNGS- UND BRÜCKENVERBINDUNGSPUNKTE FÜR ROHRFILAMENTE IN CVD-REAKTOREN
POINTS DE CONNEXION DE MANDRINS ET DE PONTS POUR FILAMENTS DE TUBE DANS UN RÉACTEUR DE DÉPÔT PAR ÉVAPORATION CHIMIQUE

(30) Priority: 23.06.2008 US 74824 P
(43) Date of publication of application: 18.05.2011
(73) Proprietor: GTAT Corporation, Merrimack, NH 03054 (US)
(72) Inventor: GUM, Jeffrey, C., Stevensville MT 59870 (US); BALLENGER, Keith, Missoula MT 59803 (US); CHARTIER, Carl, Manchester NH 03104 (US); SCHWEYEN, Andy, Missoula MT 59801 (US)
(74) Representative: Johnson, Carrie-Anne Louise
(86) International application number: PCT/US2009/003763
(87) International publication number: WO 2010/008477

(56) References cited:
- EP-A- 0 045 191
- EP-A- 0 529 593
- US-A- 3 647 530
- US-A- 4 150 168
- US-A- 4 805 556
- US-A- 5 284 640

## Description

The subject invention relates to chemical vapor deposition (CVD) reactors capable of forming materials useful in semiconductor and/or photovoltaic applications. More particularly, the subject invention relates to systems and methods for providing improved chuck and bridge connection points for tube filaments in a chemical vapor deposition reactor.

Chemical vapor deposition (CVD) is a chemical process used to produce high-purity, high-performance solid materials. The process is often used in the semiconductor and photovoltaic industries to produce high quality silicon materials. In a conventional CVD process, a rod structure is exposed to one or more volatile precursors, which react and/or decompose on the rod surface to produce the desired deposit. Frequently, volatile by-products are also produced, which can be removed by gas flow through a reaction chamber in the CVD reactor.

One method used to produce solid materials such as polysilicon by deposition in a chemical vapor deposition reactor is known as the Siemens method. When producing polysilicon using the Siemens method, polysilicon is deposited in a CVD reactor on high-purity thin silicon rods, also known as "slim rods." Because these slim rods are fabricated from high purity silicon, the corresponding electrical resistance of the slim rods is extremely high. Thus it is extremely difficult to heat the slim rods using electric current during the startup phase of the CVD process unless the slim rods are compensated with an electrically active element.

According to the Siemens method, heaters are used to raise the temperature of the slim rods to approximately 400°C in order to reduce their electrical resistivity. Typically, to accelerate the heating process, a high voltage on the order of thousands of volts is applied to the rods. Under this high voltage, a small current can begin to flow through the slim rods. This current generates heat in the slim rods, reducing the electrical resistance of the rods, and permitting yet higher current flow and additional heat to be generated by the slim rods. As the rods heat up to the desired temperature, typically greater than 800°C, the voltage is correspondingly reduced.

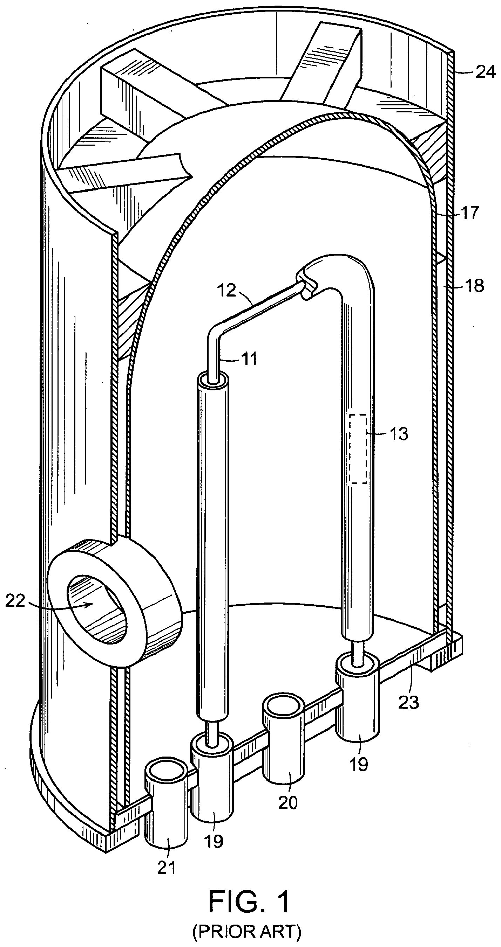

Referring to prior art FIG. 1, reproduced from FIG. 1 of U.S. Patent 6,284,312, a conventional CVD reactor may include a base plate 23, a quartz bell jar 17, a chamber cover 24, and a heater 18 positioned between the bell jar 17 and the chamber cover 24. Also, electrical feedthroughs 19 and a gas inlet and outlet 20 and 21, respectively, can be incorporated into the base plate 23. A viewing port 22 provides for visual inspection of the interior. The reactor depicted in FIG. 1 can be used to assemble a silicon slim rod structure in the form of two vertical portions 11 and 13, which are connected with a horizontal portion 12. During a CVD process, polysilicon deposits accumulate on the slim rod structure.

Connections between traditional slim rods in a CVD reactor, and between the slim rods and corresponding chucks, are important to maintaining electrical connections in the reactor. With regard to the chuck-to-filament connections, known attachment mechanisms utilize screws, bolts, clamps, etc. Known connections between slim rods are formed with a groove or a key slot at the top of each vertical rod. A small counter bore or conforming figment can be formed on the ends of the horizontal rod so that it can be press fitted into the grooves to bridge the two vertical rods.

As described in U.S. Patent 6,284,312, large diameter silicon tube filaments have been utilized to replace known slim rod designs. These designs eliminate the costly components of the prior art CVD reactor by replacing the slim rods as the core elements and target for deposition with thin-walled tube filament sections. Tube filaments provide several advantages over traditional slim rod filaments. Tube filaments require less voltage compared to traditional slim rod filaments because tube filaments can be heated to a higher temperature when using the same heating source and power output. This advantage is due to the tube filaments having a larger surface area for absorption of radiant heat relative to slim rods. In addition, improved connections between the components of the tube filament materials provide decreased resistance at the connection point and a lower total resistance to overcome initially. Therefore, a lower voltage is necessary to induce current flow through a tube filament hairpin configuration as compared to a conventional slim rod hairpin configuration. There is a need for improved systems and methods for achieving chuck-to-filament and bridge-to-filament connections for CVD reactors which utilize tube filaments in place of conventional slim rods.

The reader may be further enlightened as to the state of the art by reference to US-A-4 805 556. US-A-4 805 556 relates to the manufacture of high-purity polycrystalline silicon rods by the pyrolysis of silane. More specifically, to an improved method for pyrolyzing monosilane to form high-quality polycrystalline rods of uniform diameter and to an improved pyrolysis reactor system for forming high-quality polycrystalline silicon rods of uniform diameter at high production rates. The independent claims of the present document are, where appropriate, characterized with reference to US-A-4 805 556.

The subject invention relates to systems and methods for providing chuck and bridge connection points for tube filaments in a chemical vapor deposition (CVD) reactor. The tube filaments according to the subject invention may form a "hairpin configuration," which refers to a suitable shape of one or more tube filaments received in the CVD reactor, and may include one or more turns or curved structures of the tube filaments. The description of a "hairpin" configuration or structure is not meant to be limiting, and encompasses other configurations or structures.

Connections between the vertical tube filaments and graphite chuck supports, as well as the vertical and horizontal bridge components of a tube filament hairpin construction, are important to maintaining electrical connections and to successful deposition of solid materials such as polysilicon in a CVD reactor. These connections are referred to herein as chuck-to-filament and bridge-to-filament connection points, or simply "chuck" and "bridge" connection points, respectively. Ideally, the chuck and bridge connection points provide stability to the tube filaments to prevent mechanical failure and maintain electrical connections to the feedthroughs as well as surface area sufficient to pass electrical current to heat the tube filaments to deposition temperature during a CVD reaction cycle.

In an effort to alleviate at least some of the technical limitations of the prior art the present invention provides a chemical vapor deposition reactor system and a method of forming a tube filament on a chuck for use in a chemical vapor deposition system according to the independent claims.

These and other aspects and advantages of the subject invention will become more readily apparent from the following description of the preferred embodiments taken in conjunction with the drawings.

### BRIEF DESCRIPTION OF THE DRAWINGS

So that those skilled in the art to which the subject invention appertains will readily understand how to make and use the method and device of the subject invention without undue experimentation, preferred embodiments thereof will be described in detail herein below with reference to certain figures, wherein:
FIG. 1 (PRIOR ART) is a perspective view of a prior art CVD reactor illustrating the basic components of such a reactor;
FIG. 2 is a cross-sectional view of a CVD reactor system useful with the subject invention;
FIG. 3 is a schematic view of a tube filament pulled onto a chuck by a seed;
FIG. 4 is perspective view of chuck-to-filament connection according to a first preferred embodiment;
FIG. 5 is perspective view of chuck-to-filament connection according to a second preferred embodiment;
FIG. 6 is a perspective view of a tube filament configuration having a flat bridge connection according to a third preferred embodiment;
FIG. 7A a cross-sectional top view of a cross bridge of the flat bridge connection of FIG. 6 showing vent holes protruding through an upper surface of the cross bridge;
FIG. 7B is a bottom perspective view of a cross bridge of the flat bridge connection shown in FIG. 6;
FIG. 7C is a schematic bottom view of the cross bridge of FIG. 7B;
FIG. 8 is a perspective view of a tube filament having a rectangular bridge connection according to a fourth preferred embodiment;
FIG. 9A is a top perspective view of a cross bridge of the rectangular bridge connection shown in FIG. 8;
FIG. 9B is a schematic top view of the cross bridge of FIG. 9A;
FIG. 10 is a perspective view of a tube filament configuration having a single notched bridge connection where the cross bridge is inserted into the vertical tube filaments to complete a hairpin configuration according to the subject invention;
FIG. 11A is a cross-sectional side view of a cross bridge of the single notched bridge connection shown in FIG. 10; and
FIG. 11B is a bottom perspective view of a cross bridge of the single notched bridge connection shown in FIG. 10.

### DETAILED DESCRIPTION OF THE INVENTION

Preferred embodiments of the subject invention are described below with reference to the accompanying drawings, in which like reference numerals represent the same or similar elements.

While the description herein refers to the production of polysilicon, the techniques, devices and methods described herein are not limited to the production of polysilicon only and are useful for any material for which a CVD reactor and tube filaments are utilized. These materials may be, for example, carbon fiber, carbon nanofibers, silicon dioxide, silicon-germanium, tungsten, silicon carbide, silicon nitride, silicon oxynitride, titanium nitride, and various high-k dielectrics.

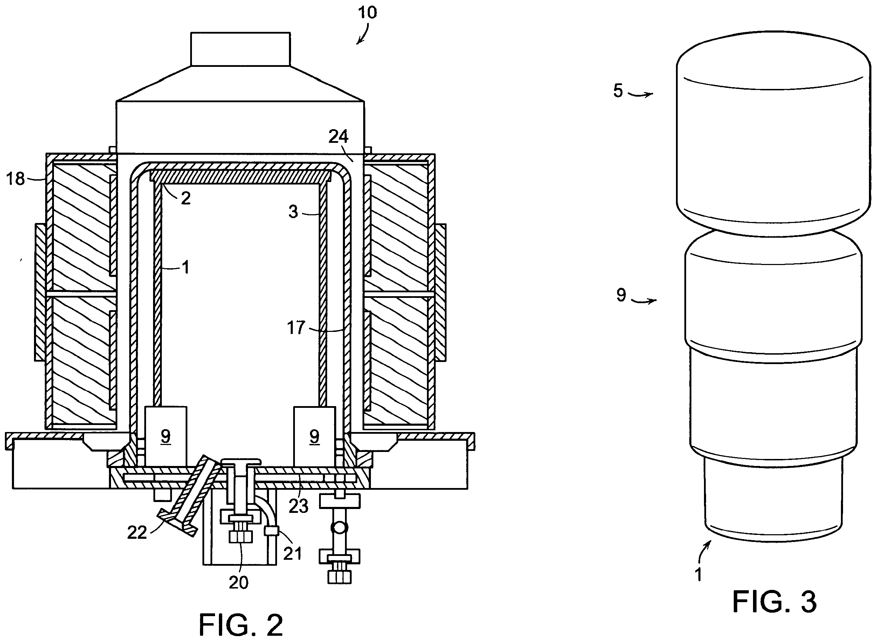

FIG. 2 is a cross-sectional view of a CVD reactor system 10 capable of being used with the subject invention. FIG. 2 as provided herein corresponds to FIG. 2 of U.S. Patent 6,284,312, which is incorporated by reference herein. While the CVD reactor system 10 utilized by the subject invention is similar to that described in U.S. Patent 6,284,312, the chuck and bridge connection points for tube filaments as described in the subject application are advantageous as compared to conventional chuck and bridge connections, and thus are described in greater detail below.

The reactor system 10 shown in FIG. 2 preferably includes a base plate 23, a quartz bell jar 17, a chamber cover 24, and at least one heater 18 positioned between the bell jar 17 and the chamber cover 24. Preferably a gas inlet 20, a gas outlet 21, and electrodes (not shown) are incorporated in the base plate 23. A viewing port 22 optionally may be included to allow for visual inspection of the interior. The system of FIG. 2 uses a tube filament (hairpin) structure for deposition of solid material, rather than the conventional slim rod configuration. The tube filament structure of the system 10 useful with the subject invention preferably incorporates vertical tube filaments 1 and 3 and a horizontal cross bridge 2.

As described above, the two primary connections in the tube filament hairpin structure are: bridge-to-filament connections (or "bridge connections"), which refer to connections between the horizontal cross bridge 2 and the vertical tube filaments 1 and 3; and chuck-to-filament connections (or "chuck connections"), which refer to connections between the vertical tube filaments 1 and 3 and the chuck 9, which can facilitate electrical connection to the electrodes for heating the tube filaments.

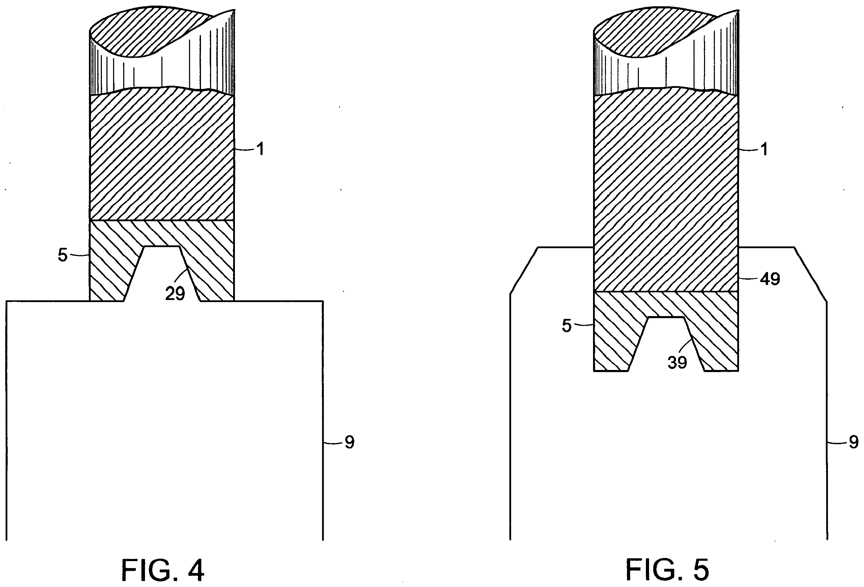

A tube filament structure utilized in the system 10 replaces the conventional slim rod structure. According to the subject invention, the tube filaments 1 and 3 are formed by connecting a graphite seed 5 to the shaft of a filament pulling machine. For example, a thin cylindrical section of the seed 5 can be dipped into a crucible filled with molten silicon. Once contact has been made, the seed 5 can be slowly withdrawn in a rotating fashion, and the cylindrical tube filament 1 is formed as it solidifies while being pulled out of the melt. The tube filament 1 is pulled to the desired length by adjusting the amount of molten silicon in the crucible. As shown in FIGS. 4 and 5, once the tube filament 1 is formed on the seed 5, it can be attached to the chuck 9 via a threaded or straight fit or any other known means. The chuck 9 is then attached to the electrode within the CVD reactor system.

Alternatively, as shown in FIG. 3, the tube filament 1 can be formed using a reusable seed 5 which is detachably connected using a threaded fit to the bottom of the chuck 9. Attached to the seed 5 at one end, the chuck 9 can be dipped into a crucible filled with molten silicon. Once contact has been made, the chuck 9 is slowly withdrawn in rotating fashion and the cylindrical tube filament 1 takes shape and forms on the chuck 9 itself and freezes while being pulled out of the melt. The tube filament formed has a hollow core. The tube filament 1 is pulled to the desired length by adjusting the amount of molten silicon in the crucible. Once the tube filament 1 is formed onto the chuck 9, the seed 5 can be removed and the chuck 9 can be directly attached to an electrode within the CVD reactor system. By repeating this process, a pair of tube filaments 1 and 3 can be produced. The seed 5 can be made of graphite, silicon carbide, silicon or another suitable material. The chuck preferably is made of carbon, silicon or another suitable material.

Because the tube filaments 1 are pulled directly onto the chuck 9 as shown in Fig. 3, the number of overall parts required for assembly in the CVD reactor is reduced. The start up resistance of the chuck-to-filament connection is also reduced because the two materials are fused together during this process instead of being mechanically connected. This process helps to reduce the connection resistance even further because there is no transition or mechanical mating of multiple parts as with traditional slim rod filament configurations.

In traditional slim rod configurations, the portion of the silicon rod which engages the graphite chuck contains an oxide layer (silicon dioxide) which has a very high resistivity, than that of silicon itself. Because this silicon dioxide layer is highly resistive, this creates a higher connection resistance. When a silicon tube filament is fused to the graphite, as described above, the oxide layer is no longer present between the silicon and graphite, and thus a lower connection resistance is provided.

The subject invention provides a beneficial way to connect the vertical tube filaments 1 and 3 to their respective chucks 9 as well as connecting the tube filaments 1 and 3 to themselves via a cross bridge 2. These connections form the basis of the tube filament hairpin configuration upon which the desired bulk material is deposited and produced. Each of the two connections will be discussed in turn.

### 1. Chuck to Filament Connection

A chuck-to-filament connection according to the subject invention can provide mechanical support to vertically aligned tube filaments 1, 3 and an electrical contact area through which current can be passed so as to provide resistive heating of the tube filament. Referring to FIG. 4, a first preferred embodiment of a chuck 9 to filament 1 connection is provided. The tube filament 1 preferably is fused to a seed 5, for example, according to the pulling process described above. This fusing of silicon to graphite eliminates the oxide layer at this connection, which in turn reduces the voltage required to begin resistive heating of the hairpin during a CVD reaction cycle. The attachment of the seed 5 to the tube filament 1 allows for less machining of the tube filament 1 itself. The chuck 9 preferably is machined so as to provide a protrusion 29 within about the center of the chuck 9 for mating with a corresponding groove or inversion within the seed 5 fused to the tube filament 1 for providing good stability and a strong electrical connection to the electrode during a CVD reaction cycle of the subject invention. Alternatively, the chuck-to-filament configuration of FIG. 4 can be formed so that the filament 1 is directly fused to the chuck 9 without the presence of the seed 5.

Referring to FIG. 5, a second preferred embodiment of the chuck 9 to filament 1 connection is provided. In this embodiment, the tube filament 1 is also fused to the seed 5. The chuck 9 preferably is machined so as to provide a protrusion 39 within about the center of the chuck 9 for mating with a corresponding inversion within the seed 5 fused to the tube filament 1 for providing good stability and a strong electrical connection to the electrode during the CVD reaction cycle. The chuck-to-filament configuration of FIG. 5 can be formed so that the filament 1 is directly fused to the chuck 9 without the presence of the seed 5. As shown in FIG. 5, the chuck 9 also preferably is machined so as to create a supporting wall 49. The supporting wall 49 provides a secure fit for the filament 1 within the chuck 9 for increased stability but has slightly less surface area for deposition of polysilicon. In this case, the reduced area for deposition is the graphite surface area only. The silicon deposited on the graphite is not typically used because it will be contaminated with carbon so this will not matter for this case. In addition, the supporting wall 49 enables increased mechanical stability of the filament 1 within the CVD reactor system.

### 2. Bridge to Filament Connection

A bridge-to-filament connection according to the subject invention can provide mechanical support to vertically aligned tube filaments 1, 3 and an electrical contact area through which current can be passed so as to provide resistive heating of the tube filament. The silicon cross bridge 2 has one or more contact point on each vertical tube filament 1, 3. The cross bridge 2 can be a tube or a rod, and can be formed in various shapes, including but not limited to: square, rectangular, and cylindrical. Preferably the contact points are distributed around the top of the tube filament 1 to form a substantially uniform current path from the electrode to the bridge 2.

Preferably a cross-sectional area of the bridge should be approximately equal to a cross-sectional area of the tube filament. Because tube filaments have greater heat loss due to their increased surface area, as compared to traditional rods, a higher current is required for the tube filaments to reach a suitable deposition temperature. Therefore, if the cross-sectional area of the bridge is much less than that of the tube filament, this could result in overheating and a possible melting of the bridge. If the cross-sectional area of the bridge is much higher than that of the tube filament, then little or no deposition is likely to occur on the bridge, as the bridge remains cooler than the tube filament. Deposition occurs optimally over the bridge and the tube filament when their cross-sectional areas are substantially matched, in order to provide adequate support for the hairpin.

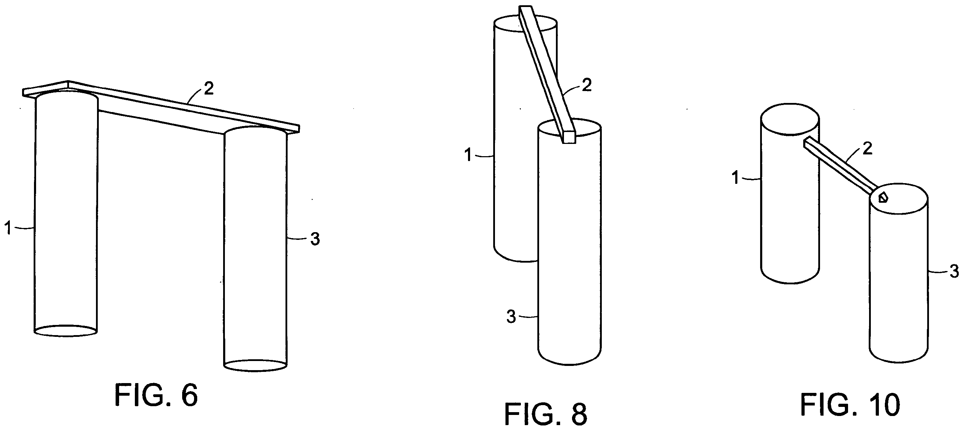

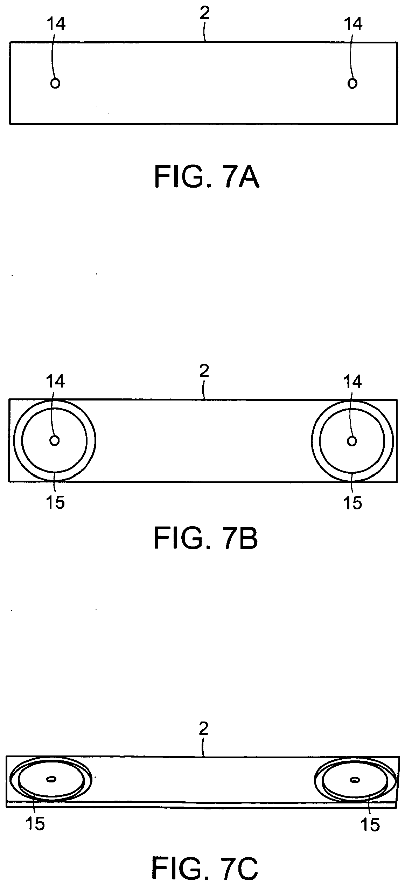

Referring to FIGS. 6 and 7A-7C, a third preferred embodiment of the subject invention is shown having a flat bridge connection. The flat bridge connection shown in FIG. 6 preferably includes a flat cross bridge 2, where the width and length of the cross bridge 2 preferably are sufficiently large to cover contact points in the tube filaments 1 and 3. As shown in FIGS. 7B and 7C, large circular recesses 15 are provided on the bottom surface of the cross bridge 2 to accommodate a wide range of thicknesses of silicon vertical filament 1 and 3 tops. The circular recesses 15 can provide a large surface area for electrical connection and improved distribution of current and heat during a CVD reaction cycle through the filaments 1 and 3. The recesses 15 are shown here as circular, but may also be other shapes.

One or more holes 14, as shown in FIG. 7A, preferably are positioned in about the middle of the circular recesses 15 to provide a vent path for air to escape the filament tubes 1 and 3 prior to introduction of process gas during a reaction cycle. In other words, the trapped air can to be taken out of the tube filament 1 at the beginning of the cycle in order to rid the tube filament 1 of air prior to introducing process gasses that may cause explosions or other safety hazards. In addition to the bridges 2 being vented, the chucks 9 are also vented to provide a path for air to escape prior to the run and for process gas to escape at the end of the run. While the bridge 2 will be grown over at the end of the run, the chucks 9 are much cooler and thus do not have a significant amount of deposition on them. The vent through the chucks 9 will then provide a path for process gasses to escape when the reactor is purged/pressure swung with nitrogen at the end of the run.

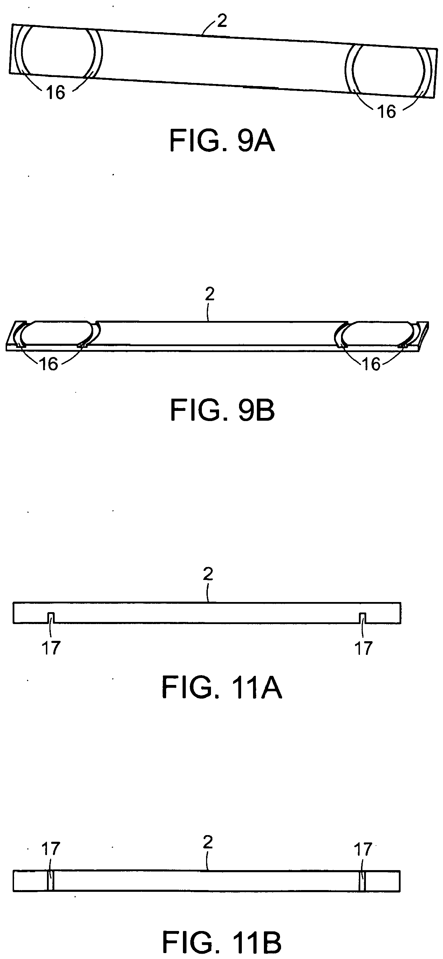

Referring to FIGS. 8 and 9A-9B, a fourth preferred embodiment of the subject invention is shown having a rectangular bridge connection. As shown in FIG. 8, the rectangular bridge connection incorporates a double-notched cross bridge 2 of reduced diameter as compared to the vertical tube filaments 1 and 3, the bridge 2 resting on top of the tube filaments 1 and 3. The flat bridge connection uses less material because it does not completely cover the entire circumference of the openings of the tube filaments 1 and 3. As a result, this embodiment can yield increased cost savings. The grooves or double notches 16 provide at least two points of contact for current flowing though the vertical tube filaments 1 and 3. Since the cross bridge 2 of this embodiment does not completely cover the openings of the filaments 1 and 3, the cross bridge 2 requires less machining, and no vent holes are needed.

Referring to FIGS. 10 and 11A-11B, a fifth preferred embodiment of the subject invention is shown having a rectangular bridge connection. A notched cross bridge 2 is provided having a reduced diameter as compared to the vertical tube filaments 1 and 3 inserted into holes on the upper portion of the tube filaments. The cross bridge 2 preferably has tapered edges that fit into corresponding holes that can be drilled into the tube filaments 1 and 3. This embodiment provides increased stability under high gas flows as it is completely surrounded by the filament hole at the connection points. Also, machining can be reduced due to the simple design, and cost savings achieved by using less material. As shown in FIGS. 11A and 11B, at least one notch 17 is provided at each end of the cross bridge 2. The notches 17 engage side walls of the vertical tube filaments 1 and 3 in order to form a connection. In an alternative embodiment, the notched cross-bridge 2 engages the upper surface of the tube filaments 1 and 3 instead of in the holes in the walls of the upper portion of the tubes 1 and 3.

The embodiments described above are not necessarily alternatives, and may be used together in the same reactor. For example, the first preferred embodiment, which is a chuck-to-filament connection shown in FIG. 4 can be used in the same reactor with a bridge-to-filament connection such as the third preferred embodiment depicted in FIGS. 7 and 8A-8C. Similarly, different chuck-to-filament connections and different bridge-to-filament connection can be used together in the same reactor. Although the subject invention has been described with respect to preferred embodiments, those skilled in the art will readily appreciated that changes or modifications thereto may be made without departing from the scope of the subject invention as defined by the appended claims.

## Claims

1. A chemical vapor deposition reactor system, comprising:
at least a first tube filament (1,3) having first and second ends, the tube filament (1,3) configured to carry an electrical current;
a seed (5) attached to the first end of the tube filament (1,3);
a chuck (9) connected to at least the seed (5), wherein the chuck (9) is formed with a protrusion (29, 39) that corresponds to a groove of the seed (5), such that the chuck (9) is electrically connected to the tube filament (1,3);
at least a second tube filament (1,3), said second tube filament having first and second ends, each tube filament (1,3) being connected to a respective seed (5) and chuck (9); and
a bridge (2) connecting the first and second tube filament (1,3), wherein the bridge comprises a plurality of recesses (15), each of the recesses (15) for engaging one of the first ends of the first and second tube filaments (1,3).

2. The system of claim 1, wherein the protrusion (29, 39) is positioned in a center of the chuck (9).

3. The system of claim 1 or claim 2, wherein the seed (5) is detachable from the chuck (9).

4. The system of any preceding claim, wherein the seed (5) is attached to the chuck (9) after formation of the tube filament (1,3).

5. The system of any of preceding claim, wherein the seed (5) is made of graphite.

6. The system of any preceding claim, wherein the recesses (15) each have at least one vent hole (14) for providing a vent path.

7. The system of any preceding claim, wherein the bridge is configured to completely overlap a circumference of the first ends of the first and second tube filaments (1,3).

8. The system of any preceding claim, wherein the bridge (2) comprises grooves for engaging at least a portion of one of the first ends of the first and second tube filaments (1,3).

9. The system of claim 8, wherein the bridge (2) is configured so as not to completely overlap a circumference of the first ends of the first and second tube filaments (1,3).

10. The system of any preceding claim, wherein the bridge includes a plurality of notches for engaging the first and second tube filaments (1,3).

11. The system of any preceding claim, wherein:
the bridge (2) has a contact portion for mechanically engaging the at least one tube filament (1,3); and
the contact portion having at least one recess (17) for engaging the first end of the tube filament (1,3).

12. The system of claim 11, wherein the at least one recess (17) further comprises at least one vent hole (14).

13. The system of claim 11 or 12, wherein the contact portion is configured to completely overlap a circumference of the first end.

14. The system of claim 11 or 12, wherein the contact portion is configured so as not to completely overlap the circumference of the first end.

15. The system of any preceding claim, wherein the bridge is made of silicon.

16. A method of forming a tube filament (1,3) on a chuck (9) for use in a chemical vapor deposition reactor, comprising the steps of:
providing a seed (5) with a groove;
connecting a chuck (9) having a protrusion (29,39) to the seed (5) with the protrusion received into the groove;
inserting at least a portion of the chuck (9) into a silicon melt;
withdrawing the chuck (9) from the silicon melt such that a tube filament (1,3) is formed on the seed (5); and
connecting the tube filament (1,3) to the chuck (9).

17. The method of claim 16, wherein the seed (5) is a reusable seed (5).

18. The method of claim 17, further comprising the step of: detaching the reusable seed (5) from the chuck (9).

19. The method of any of claims 16 to 18, wherein the silicon melt is contained in a crucible.

20. The method of claim 19, further comprising the step of: adjusting a length of the tube filament (1,3) based on an amount of molten material contained in the crucible.

## Patentansprüche

1. Chemisches Gasphasenabscheidungsreaktorsystem, umfassend:
mindestens ein erstes Rohrfilament (1, 3) mit ersten und zweiten Enden, wobei das Rohrfilament (1, 3) zum Führen eines elektrischen Stroms konfiguriert ist;
einen Kern (5), der an dem ersten Ende des Rohrfilaments (1, 3) angebracht ist;
eine Spannvorrichtung (9), die mindestens mit dem Kern (5) verbunden ist, wobei die Spannvorrichtung (9) mit einem Vorsprung (29, 39) ausgebildet ist, der einer Ausnehmung des Kerns (5) derart entspricht, dass die Spannvorrichtung (9) elektrisch mit dem Rohrfilament (1, 3) verbunden wird;
mindestens ein zweites Rohrfilament (1, 3), wobei das zweite Rohrfilament erste und zweite Enden aufweist, wobei jedes Rohrfilament (1, 3) mit einem entsprechenden Kern (5) und einer entsprechenden Spannvorrichtung (9) verbunden ist;
und
eine Brücke (2), welche das erste und das zweite Rohrfilament (1, 3) verbindet, wobei die Brücke mehrere Vertiefungen (15) aufweist, wobei jede der Vertiefungen (15) für den Eingriff mit einem der ersten Enden der ersten und zweiten Rohrfilamente (1, 3) vorgesehen ist.

2. System nach Anspruch 1, wobei der Vorsprung (29, 39) in einer Mitte der Spannvorrichtung (9) positioniert ist.

3. System nach Anspruch 1 oder 2, wobei der Kern (5) von der Spannvorrichtung (9) ablösbar ist.

4. System nach einem der vorhergehenden Ansprüche, wobei der Kern (5) nach der Bildung des Rohrfilaments (1, 3) an der Spannvorrichtung (9) angebracht wird.

5. System nach einem der vorhergehenden Ansprüche, wobei der Kern (5) aus Graphit hergestellt ist.

6. System nach einem der vorhergehenden Ansprüche, wobei die Vertiefungen (15) jeweils mindestens eine Entlüftungsöffnung (14) für das Bereitstellen eines Entlüftungspfades aufweisen.

7. System nach einem der vorhergehenden Ansprüche, wobei die Brücke konfiguriert ist, einen Umfang der ersten Enden der ersten und zweiten Rohrfilamente (1, 3) vollständig zu überlappen.

8. System nach einem der vorhergehenden Ansprüche, wobei die Brücke (2) Ausnehmungen für den Eingriff mit mindestens einem Abschnitt von einem der ersten Enden der ersten und zweiten Rohrfilamente (1, 3) aufweist.

9. System nach Anspruch 8, wobei die Brücke (2) konfiguriert ist, einen Umfang der ersten Enden der ersten und zweiten Rohrfilamente (1, 3) nicht vollständig zu überlappen.

10. System nach einem der vorhergehenden Ansprüche, wobei die Brücke mehrere Einschnitte zum Eingriff mit den ersten und zweiten Rohrfilamenten (1, 3) aufweist.

11. System nach einem der vorhergehenden Ansprüche, wobei:
die Brücke (2) einen Kontaktabschnitt für den mechanischen Eingriff mit dem mindestens einen Rohrfilament (1, 3) aufweist; und
der Kontaktabschnitt mindestens eine Vertiefung (17) für den Eingriff mit dem ersten Ende des Rohrfilaments (1, 3) aufweist.

12. System nach Anspruch 11, wobei die mindestens eine Vertiefung (17) ferner mindestens eine Entlüftungsöffnung (14) aufweist.

13. System nach Anspruch 11 oder 12, wobei der Kontaktabschnitt konfiguriert ist, einen Umfang des ersten Endes vollständig zu überlappen.

14. System nach Anspruch 11 oder 12, wobei der Kontaktabschnitt konfiguriert ist, den Umfang des ersten Endes nicht vollständig zu überlappen.

15. System nach einem der vorhergehenden Ansprüche, wobei die Brücke aus Silizium hergestellt ist.

16. Verfahren zum Bilden eines Rohrfilaments (1, 3) an einer Spannvorrichtung (9) zur Verwendung in einem chemischen Gasphasenabscheidungsreaktor, umfassend die Schritte:
Bereitstellen eines Kerns (5) mit einer Ausnehmung;
Verbinden einer Spannvorrichtung (9), die einen Vorsprung (29, 39) aufweist, mit dem Kern (5), wobei der Vorsprung in der Ausnehmung aufgenommen wird;
Einführen von mindestens einem Abschnitt der Spannvorrichtung (9) in eine Siliziumschmelze;
Zurückziehen der Spannvorrichtung (9) aus der Siliziumschmelze derart, dass ein Rohrfilament (1, 3) auf dem Kern (5) ausgebildet wird; und
Verbinden des Rohrfilaments (1, 3) mit der Spannvorrichtung (9).

17. Verfahren nach Anspruch 16, wobei der Kern (5) ein wiederverwendbarer Kern (5) ist.

18. Verfahren nach Anspruch 17, ferner umfassend den Schritt: Ablösen des wiederverwendbaren Kerns (5) von der Spannvorrichtung (9).

19. Verfahren nach einem der Ansprüche 16 bis 18, wobei die Siliziumschmelze in einem Tiegel enthalten ist.

20. Verfahren nach Anspruch 19, ferner umfassend den Schritt: Einstellen einer Länge des Rohrfilaments (1, 3) auf der Basis einer Menge an geschmolzenem Material, das in dem Tiegel enthalten ist.

## Revendications

1. Système de réacteur de dépôt chimique en phase vapeur, comprenant :
au moins un premier filament tubulaire (1, 3) ayant une première et une deuxième extrémité, le filament tubulaire (1, 3) étant configuré pour conduire un courant électrique ;
un germe (5) attaché à la première extrémité du filament tubulaire (1, 3) ;
un mandrin (9) connecté au moins au germe (5), le mandrin (9) étant formé avec une saillie (29, 39) qui correspond à une rainure du germe (5), de telle sorte que le mandrin (9) soit connecté électriquement au filament tubulaire (1, 3) ;
au moins un deuxième filament tubulaire (1, 3), ledit deuxième filament tubulaire ayant une première et une deuxième extrémité, chaque filament tubulaire (1, 3) étant connecté respectivement à un germe (5) et à un mandrin (9) ; et
un pont (2) reliant le premier et le deuxième filament tubulaire (1, 3), le pont comprenant une pluralité de renfoncements (15), chacun des renfoncements (15) servant à l'engagement d'une des premières extrémités des premier et deuxième filaments tubulaires (1, 3).

2. Système selon la revendication 1, dans lequel la saillie (29, 39) est positionnée dans un centre du mandrin (9).

3. Système selon la revendication 1 ou la revendication 2, dans lequel le germe (5) peut être détaché du mandrin (9).

4. Système selon l'une quelconque des revendications précédentes, dans lequel le germe (5) est attaché au mandrin (9) après la formation du filament tubulaire (1, 3).

5. Système selon l'une quelconque des revendications précédentes, dans lequel le germe (5) est fabriqué en graphite.

6. Système selon l'une quelconque des revendications précédentes, dans lequel les renfoncements (15) présentent chacun au moins un trou de ventilation (14) pour fournir un chemin de ventilation.

7. Système selon l'une quelconque des revendications précédentes, dans lequel le pont est configuré pour chevaucher complètement une circonférence des premières extrémités des premier et deuxième filaments tubulaires (1, 3).

8. Système selon l'une quelconque des revendications précédentes, dans lequel le pont (2) comprend des rainures pour l'engagement d'au moins une partie d'une des premières extrémités des premier et deuxième filaments tubulaires (1, 3).

9. Système selon la revendication 8, dans lequel le pont (2) est configuré de manière à ne pas chevaucher complètement une circonférence des premières extrémités des premier et deuxième filaments tubulaires (1, 3).

10. Système selon l'une quelconque des revendications précédentes, dans lequel le pont comporte une pluralité d'encoches pour l'engagement des premier et deuxième filaments tubulaires (1, 3).

11. Système selon l'une quelconque des revendications précédentes, dans lequel :
le pont (2) présente une portion de contact pour l'engagement mécanique de l'au moins un filament tubulaire (1, 3) ; et
la portion de contact présente au moins un renfoncement (17) pour l'engagement de la première extrémité du filament tubulaire (1, 3).

12. Système selon la revendication 11, dans lequel l'au moins un renfoncement (17) comprend en outre au moins un trou de ventilation (14).

13. Système selon la revendication 11 ou 12, dans lequel la portion de contact est configurée pour chevaucher complètement une circonférence de la première extrémité.

14. Système selon la revendication 11 ou 12, dans lequel la portion de contact est configurée de manière à ne pas complètement chevaucher la circonférence de la première extrémité.

15. Système selon l'une quelconque des revendications précédentes, dans lequel le pont est fabriqué en silicium.

16. Procédé de formation d'un filament tubulaire (1, 3) sur un mandrin (9) pour l'utilisation dans un réacteur de dépôt chimique en phase vapeur, comprenant les étapes suivantes :
fournir un germe (5) avec une rainure ;
connecter un mandrin (9) ayant une saillie (29, 39) au germe (5), la saillie étant reçue dans la rainure ;
insérer au moins une portion du mandrin (9) dans une matière de silicium en fusion ;
retirer le mandrin (9) de la matière de silicium en fusion de telle sorte qu'un filament tubulaire (1, 3) soit formé sur le germe (5) ; et
connecter le filament tubulaire (1, 3) au mandrin (9) .

17. Procédé selon la revendication 16, dans lequel le germe (5) est un germe réutilisable (5).

18. Procédé selon la revendication 17, comprenant en outre l'étape consistant à détacher le germe réutilisable (5) du mandrin (9).

19. Procédé selon l'une quelconque des revendications 16 à 18, dans lequel la matière de silicium en fusion est contenue dans un creuset.

20. Procédé selon la revendication 19, comprenant en outre l'étape consistant à ajuster une longueur du filament tubulaire (1, 3) sur la base d'une quantité de matière en fusion contenue dans le creuset.
